# FASCICULE DE BREVET EUROPEEN

(11) **EP 4 539 101 B1**
(45) Date de publication et mention de la délivrance du brevet: **21.01.2026**
(21) Numéro de dépôt: 24204440.2
(22) Date de dépôt: 03.10.2024
(51) Int. Cl.: H01L 21/20, C30B 29/40, H10H 20/00

(54) **PROCÉDÉ DE RÉALISATION D'UNE COUCHE CONTINUE DE NITRURE**
VERFAHREN ZUR HERSTELLUNG EINER ZUSAMMENHÄNGENDEN NITRIDSCHICHT
METHOD FOR PRODUCING A CONTINUOUS NITRIDE LAYER

(30) Priorité: 09.10.2023 FR 2310758
(43) Date de publication de la demande: 16.04.2025
(73) Titulaire: Commissariat à l'Energie Atomique et aux Energies Alternatives, 75015 Paris (FR); Centre National de la Recherche Scientifique, 75016 Paris (FR); Université Grenoble Alpes, 38401 Saint-Martin-d'Hères (FR); Institut Polytechnique de Grenoble, 38000 Grenoble (FR)
(72) Inventeur: CHARLES, Matthew, 38054 Grenoble Cedex 09 (FR); DAGHER, Roy, 06600 Antibes (FR); FEUILLET, Guy, 38054 Grenoble Cedex 09 (FR); ZUNIGA PEREZ, Jesus, 298189 Singapore (SG); GOURGON, Cécile, 38110 Saint Didier de la Tour (FR)
(74) Mandataire: Hautier IP

(56) Documents cités:
- US-A1- 2003 030 068
- US-A1- 2022 251 730

## Description

### DOMAINE TECHNIQUE

La présente invention concerne la réalisation de couches continues faites d'un nitrure (N) obtenu de préférence à partir d'au moins l'un parmi le gallium (Ga), l'indium (In) et l'aluminium (AI). L'invention trouve par exemple pour application le domaine des dispositifs optoélectroniques comprenant une pluralité de diodes électroluminescentes (LED) de taille micrométrique, généralement appelées micro-LEDs. Dans ce domaine, une utilisation particulièrement avantageuse de l'invention concerne la réalisation d'écrans de faible taille généralement appelés micro-écrans ou encore micro-displays.

### ETAT DE LA TECHNIQUE

Pour de nombreuses applications micro-électroniques ou optoélectroniques, on souhaite réaliser des couches de nitrure à partir d'au moins l'un parmi le gallium, l'indium et l'aluminium. Des applications spécifiques concernent par exemple la réalisation de micro-LEDs.

Une couche de nitrure est classiquement obtenue par croissance épitaxiale à partir d'une couche cristalline recouvrant une plaque.

Un enjeu majeur consiste à minimiser la densité de défauts dans la couche de nitrure obtenue par épitaxie. En effet, les performances des dispositifs micro-électroniques ou optoélectroniques réalisés à partir de ces couches de nitrure sont très sensibles à la densité de défauts de structure tels que les dislocations.

Ces dislocations ont pour origine la différence de paramètre de maille entre la couche épitaxiée et le substrat, ainsi que la coalescence des grains de faible dimension qui sont formés au début de la croissance ; ces grains sont légèrement désorientés les uns par rapport aux autres et ils se joignent en formant au niveau du joint de coalescence des défauts structuraux, dont des dislocations, qui peuvent traverser ensuite toute la structure épitaxiée.

La façon la plus directe pour résoudre ces problèmes consiste à utiliser des substrats de même nature que les couches que l'on veut épitaxier (homo-substrats). Cependant, ces substrats ne sont pas disponibles commercialement ou ne sont encore que de faibles dimensions, et sont très chers, ce qui ne permet pas d'y découper des substrats de dimensions suffisantes pour les applications industrielles envisagées.

Les solutions envisagées à ce jour pour des applications industrielles reposent donc principalement sur l'utilisation d'hétéro-substrats en combinaison avec des méthodes dites de « recroissance latérale » ou ELOG, acronyme de l'anglais « epitaxial lateral overgrowth ». Cette méthode, basée sur l'utilisation d'un masque pour bloquer les dislocations, permet de réduire la densité de ces dernières. En revanche, ces dislocations sont distribuées de façon non uniforme, ce qui peut poser problème lors de la fabrication des dispositifs.

Une autre solution consiste à faire recroitre par épitaxie du matériau sur des plots préexistants de ce matériau : il s'agit du procédé dit de pendeo-épitaxie qui permet de s'affranchir de la recroissance sur le masque. **En** revanche, les solutions classiques de pendeo-épitaxie ne permettent pas d'éliminer, voire de réduire significativement, l'apparition de défauts générés par la coalescence de germes adjacents.

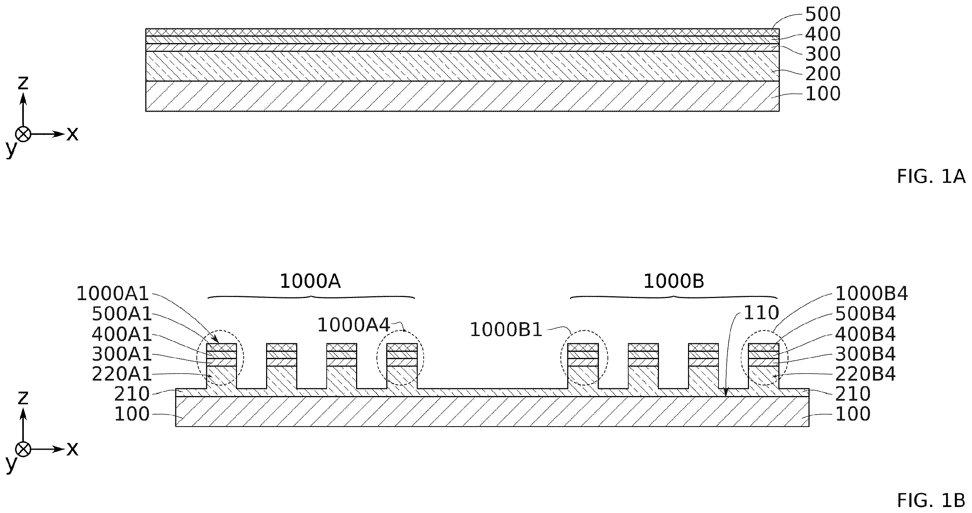

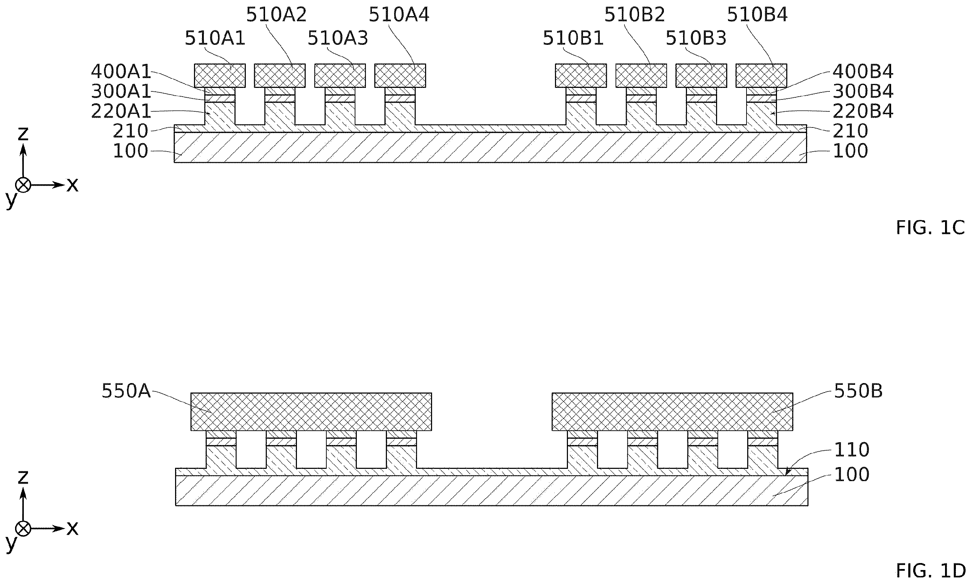

La demande de brevet WO2019122461 décrit une solution illustrée aux figures 1A à 1D :
a. Une première étape consiste à fournir un empilement comprenant une couche de fluage 200, une couche cristalline 300 et une couche de nitrure 500 ou couche d'amorçage 500, typiquement une couche de nitrure de gallium (GaN). Une couche tampon 400 peut également être présente entre la couche de fluage et la couche de nitrure 500. Cette étape est illustrée en figure 1A.
b. Une deuxième étape consiste à former des plots 1000A1-1000A4, 1000B1-1000B4 par gravure de la couche cristalline 300, éventuellement de la couche tampon 400, et d'au moins une portion de la couche de fluage 200 (figure 1B). Chaque plot comprend ainsi un tronçon de fluage 220A1-220A4, 220B1-220B4 issu de la couche de fluage 200 et un tronçon cristallin 300A1-300A4, 300B1-300B4 issu de la couche cristalline 300.
c. Faire croître par épitaxie des cristallites 510A1-510A4, 510B1-510B4 sur les plots 1000A1-1000A4, 1000B1-1000B4 et ce jusqu'à leur coalescence (figures 1C et 1D). La couche ainsi formée peut poursuivre sa croissance en s'épaississant.

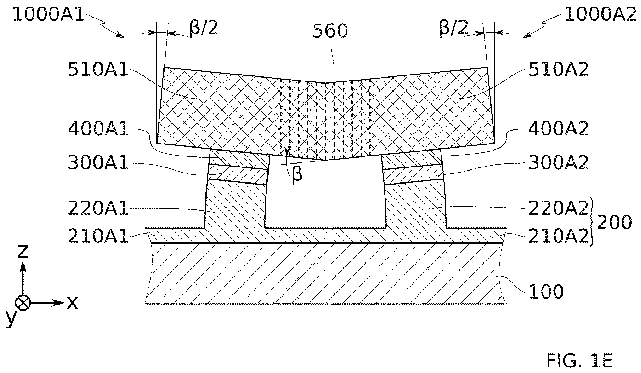

Au cours de leur croissance épitaxiale, les cristallites formées au sommet des plots coalescent pour former une couche continue destinée à former un dispositif optoélectronique ou électronique. Lors de l'épitaxie, la portion du plot qui est formée par le tronçon de fluage atteint (ou dépasse) sa température de transition vitreuse ou une température très proche de cette dernière. Sous l'effort d'une contrainte mécanique, cette portion de plot peut ainsi se déformer (figure 1E). Ainsi, lorsque deux cristallites entrent en contact et coalescent, les contraintes mécaniques générées par ce contact sont transférées aux plots et donc aux tronçons de fluage les soutenant. Ces derniers se déforment, absorbant de ce fait une partie des contraintes mécaniques. Cette mobilité des plots du fait de la présence des tronçons de fluage permet notamment d'accommoder des désorientations relatives des cristallites entre elles, que ce soit dans le plan dans lequel le substrat s'étend principalement (« twist ») ou hors plan (« tilt »).

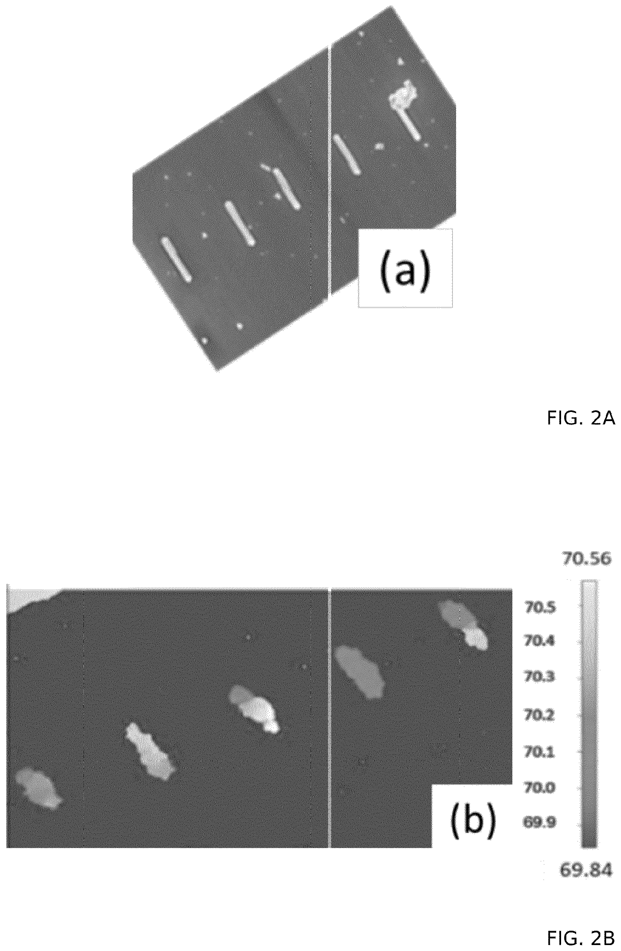

Il apparaît cependant que cette méthode ne permet pas d'obtenir des densités de défauts satisfaisantes. Comme illustré aux figures 2A et 2B, des couches continues obtenues par un tel procédé présentent par endroit des angles d'orientation du matériau à la base de la couche nitrure très élevés, traduisant l'existence de défauts structuraux dommageables pour la fabrication de dispositifs à partir de ces couches continues.

Il existe donc un besoin consistant à limiter voire à supprimer les inconvénients des solutions connues. La présente invention a notamment pour objectif de proposer une solution pour répondre à ce besoin.

Un objectif de la présente invention est de proposer une solution pour obtenir une couche de nitrure (N) obtenue à partir d'au moins l'un parmi le gallium (Ga), l'indium (In) et l'aluminium (AI), présentant une densité de défauts significativement réduite.

Autre état de la technique est connu de US 2022/0251730 A1 et US 2003/0030068 A1.

### RESUME

Pour atteindre cet objectif, selon un mode de réalisation on prévoit un procédé d'obtention d'une couche faite au moins en partie d'un nitrure (N) obtenu de préférence à partir d'au moins l'un parmi le gallium (Ga), l'indium (In) et l'aluminium (AI), comprenant les étapes suivantes :
a. fournir un empilement comprenant au moins un ensemble de plots s'étendant depuis un substrat, chaque plot comprenant au moins :
   i. un premier tronçon, dit tronçon de fluage, formé dans un matériau amorphe présentant une température de transition vitreuse T_{transition vitreuse},
   ii. un deuxième tronçon, cristallin, dit tronçon cristallin, surmontant le tronçon de fluage,
b. faire croître par épitaxie une cristallite sur certains au moins desdits plots et poursuivre la croissance épitaxiale des cristallites jusqu'à coalescence des cristallites portées par les plots de l'ensemble de plots, de manière à former une couche de nitrure,

Le procédé est caractérisé en ce que les plots dudit ensemble de plots sont répartis sur le substrat de façon à ce que la disposition relative des plots de l'ensemble de plots soit telle qu'au cours de l'épitaxie des cristallites, la coalescence progressive des cristallites se fasse toujours entre d'une part un ensemble, dit ensemble coalescé, comprenant une cristallite ou une pluralité de cristallites coalescées et d'autre part au moins une cristallite, dite cristallite isolée, n'ayant pas déjà coalescé avec d'autres cristallites.

Ainsi, en un point de coalescence, la coalescence progressive des cristallites se fait toujours entre d'une part une cristallite ou une pluralité de cristallites coalescées et d'autre part une cristallite unique, pouvant également être qualifiée de cristallite isolée puisqu'elle n'a au préalable pas coalescée avec une ou plusieurs autres cristallites. Le tronçon de fluage sous-jacent à ladite cristallite isolée dispose de toute la mobilité nécessaire pour compenser les éventuels désalignements et désorientations entre la cristallite isolée et la cristallite ou la pluralité de cristallites coalescées à laquelle elle coalesce. On évite ainsi la formation de défauts structuraux au sein des cristallites et donc de la couche continue lors des coalescences successives, ce qui permet d'obtenir in fine une couche continue d'excellente qualité.

Des dispositifs électroniques et optoélectroniques, par exemple des LED ou des dispositifs verticaux tels que des transistors verticaux ou des composants latéraux comme des transistors HEMT, présentant de très bonnes performances peuvent ainsi être fabriqués à partir de ces couches présentant de faibles densités de défauts structuraux.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1A à 1E illustrent des étapes d'un procédé de formation d'une couche continue selon l'art antérieur.
La figure 2A est une photo obtenue au microscope électronique à balayage (MEB) qui illustre des couches continues obtenues par le procédé illustré aux figures 1A à 1E.
La figure 2B est une image obtenue par microscopie à rayon X en champ sombre montrant les variations d'orientation des cristallites obtenues par le procédé illustré aux figures 1A à 1E.
Les figures 3A à 3H illustrent des étapes d'un procédé selon un exemple non limitatif du procédé selon la présente invention. La figure 3A illustre un exemple d'empilement à partir duquel l'on peut mettre en œuvre un exemple de procédé selon l'invention.
La figure 3B illustre l'empilement de la figure 3A sur lequel une couche d'amorçage est formée.
La figure 3C illustre le résultat d'une étape consistant à former un ensemble de plots à partir de l'empilement de la figure 3A ou de celui de la figure 3B.
La figure 3D illustre une phase de croissance épitaxiale de cristallites sur le sommet des plots, cette phase de croissance n'étant pas achevée.
Les figures 3E à 3H illustrent les coalescences successives des cristallites pour former une couche continue.
Les figures 4A à 4F illustrent des exemples de dispositions de plots permettant la fabrication de couches continues présentant une faible densité de défauts. Les figures 4A et 4B illustrent un exemple dans lequel les plots sont disposés selon une spirale logarithmique.
La figure 4C illustre un exemple dans lequel certains des plots sont disposés selon plusieurs axes d'alignement parallèles.
La figure 4D illustre un exemple dans lequel les plots sont disposés selon un axe d'alignement.
Les figures 4E et 4F illustrent un exemple dans lequel les plots sont disposés selon cinq axes d'alignement concourants.
Les figures 5A et 5B représentent la coalescence de deux couches continues elles-mêmes préalablement formées par la coalescence de cristallites.
La figure 6A est une image MEB de quatre ensembles chacun formé de trois plots de silicium (tronçon de fluage) et de GaN (tronçon cristallin surmontant le tronçon de fluage), le tout étant porté par un substrat silicium sur isolant (SOI).
La figure 6B est une image MEB des ensembles illustrés sur la figure 6A après coalescence des plots d'un même ensemble.
La figure 7 illustre des résultats obtenus par analyse par diffraction des rayons X illustrant l'orientation des couches de GaN obtenues par coalescence des plots.
La figures 8A et 8B illustrent des résultats obtenus par analyse par diffraction des rayons X illustrant l'orientation des tronçons de silicium après coalescence des plots.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches, tronçons, cristallites et couches continues ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un mode de réalisation avantageux, les plots portant les cristallites formant la couche de nitrure sont sensiblement disposés, en projection dans un plan horizontal dans lequel s'étend principalement la face supérieure du substrat, selon une spirale logarithmique.

Selon un mode de réalisation, les plots portant les cristallites formant la couche continue de nitrure sont, en projection dans un plan horizontal dans lequel s'étend principalement la face supérieure du substrat, sensiblement alignés selon au moins un axe dit d'alignement.

Selon un mode de réalisation, les plots disposés sur un même axe d'alignement sont espacés d'une distance croissante en parcourant l'axe d'alignement selon un sens donné à partir d'un point donné, dit point initial.

Selon un exemple, les plots portant les cristallites formant la couche continue sont séparés d'une distance variant de façon logarithmique de proche en proche, ladite distance étant mesurée selon leur axe d'alignement.

Selon un exemple, les plots portant les cristallites formant la couche continue de nitrure sont sensiblement alignés, en projection dans un plan horizontal dans lequel s'étend principalement la face supérieure du substrat, selon des axes concourants, les axes concourants vérifiant entre eux une symétrie de rotation autour d'un point central en projection dans le plan horizontal.

Selon un exemple, les plots sont alignés selon cinq axes concourants.

Selon un exemple, la croissance épitaxiale est effectuée à une température T_{épitaxie}, telle que T_{épitaxie} > k₁ x Tₜᵣₐₙₛᵢₜᵢₒₙ vitreuse, avec k₁ ≥ 0,8.

Selon un exemple, k₁ ≥ 1, et de préférence k₁ ≥ 1,5.

Avantageusement, l'ensemble de plots comprend au moins 3 plots.

Selon un mode de réalisation, l'empilement comprend une pluralité d'ensembles de plots sur le substrat, une couche continue de nitrure étant formée à partir de chaque ensemble de plots, la croissance par épitaxie des cristallites étant interrompue avant que les cristallites appartenant à deux ensembles de plots distincts n'entrent en coalescence, de sorte à ce que les couches continues formées à partir de chaque ensemble de plots soient distantes les unes des autres.

Dans ce mode de réalisation dans lequel plusieurs ensembles permettent de former plusieurs couches continues et disjointes les unes des autres sur une même plaque, ces différentes couches continues sont typiquement désignées « vignettes ». Chacune de ces vignettes peut être ensuite impliquée dans la réalisation d'un disposition électronique ou optoélectronique, telle une **LED** ou micro-LED ou un dispositif vertical tel qu'un transistor vertical. Les caractéristiques décrites ci-dessous en référence à un ensemble de plots, ses cristallites et à la couche continue formée à partir de cet ensemble de plots s'appliquent mutatis mutandis aux autres ensembles de plots, les cristallites qu'ils portent et les couches continues formées par coalescence de ces cristallites.

Selon un exemple, chaque plot présente une face supérieure et dans lequel la croissance par épitaxie des cristallites s'effectue en partie au moins et de préférence uniquement à partir de ladite face supérieure.

Selon un exemple, le procédé comprend en outre une étape de formation dans la couche continue d'un dispositif, le dispositif étant pris parmi une LED et un transistor, par exemple un transistor vertical, par exemple un transistor de type HEMT.

Selon un mode de réalisation, les plots dudit ensemble de plots sont répartis sur le substrat de façon à ce que la disposition relative des plots de l'ensemble de plots soit telle qu'au cours de l'épitaxie des cristallites, au moins à certains instants la coalescence progressive des cristallites se fait entre d'une part ledit ensemble coalescé et d'autre part plusieurs cristallites isolées.

Alternativement, les plots dudit ensemble de plots sont répartis sur le substrat de façon à ce que la disposition relative des plots de l'ensemble de plots soit telle qu'au cours de l'épitaxie des cristallites, la coalescence progressive des cristallites se fait toujours entre d'une part ledit ensemble coalescé et d'autre part une seule cristallite isolée.

Selon un exemple, chaque plot présente une section dont la dimension maximale dₚₗₒₜ est comprise entre 10 et 500 nm (10⁻⁹ mètres), la dimension maximale dₚₗₒₜ étant mesurée dans un plan parallèle à un plan horizontal dans lequel s'étend principalement la face supérieure du substrat, de préférence 20 nm ≤ dₚₗₒₜ ≤ 200 nm et de préférence 50 nm ≤ dₚₗₒₜ ≤ 100 nm.

Selon un exemple préféré, la couche continue présente une section dont la dimension maximale d_{couche} est comprise entre 0,5 à 10 µm (10⁻⁶ mètres), la dimension maximale d_{couche} étant mesurée dans un plan parallèle à un plan horizontal dans lequel s'étend principalement la face supérieure du substrat, de préférence 0.8 µm ≤ d_{couche} ≤ 3 µm et de préférence 1 µm ≤ d_{couche} ≤ 2 µm.

De préférence, la couche de fluage est faite d'un matériau pris parmi :
a. un oxyde de silicium SixOy, x et y étant des entiers, et de préférence la couche de fluage est en SiO2,
b. un verre,
c. un verre en borosilicate,
d. un verre en borophosphosilicate (BPSG).

Avantageusement, T_{épitaxie} ≤ k₂ x T_{fusion min}, T_{fusion min} étant la température de fusion la plus faible parmi les températures de fusion des tronçons formant les plots, avec k₂ ≤ 0,9 et de préférence k₂ ≤ 0,8.

Selon un mode de réalisation avantageux, les plots comprennent au moins une couche tampon surmontant la couche cristalline, et faite en un matériau différent de celui de la couche continue de nitrure, et de préférence la couche continue de nitrure est faite en nitrure de gallium (GaN) et la couche tampon est en nitrure d'aluminium (AIN). Cela permet d'éviter les phénomènes d'altération de la couche de GaN par réaction avec la couche de silicium, phénomènes habituellement qualifiés de « melt-back etching »).

Selon un exemple, les plots comprennent, avant l'étape de croissance épitaxiale des couches continues de nitrure, au moins une couche d'amorçage, surmontant ladite couche tampon et faite de nitrure de gallium (GaN).

Selon un exemple avantageux, fournir ledit empilement comprend fournir un substrat élaboré de type silicium sur isolant (SOI) comprenant un substrat de base surmonté successivement d'une couche d'oxyde formant ladite couche de fluage et d'une couche semi conductrice formant ladite couche cristalline.

Selon un exemple avantageux, le tronçon de fluage présente une hauteur e₂₂₀ telle que e₂₂₀ ≥ 0.1xdₚₗₒₜ, Aₚₗₒₜ étant le diamètre du plot ou plus généralement la distance bord à bord du plot prise, au niveau du tronçon de fluage et dans une direction parallèle à un plan horizontal dans lequel s'étend principalement une face supérieure du substrat, de préférence e₂₂₀ ≥ 1xdₚₗₒₜ.

Selon un exemple, l'étape de formation des plots comprend la gravure de la couche cristalline et la gravure d'une portion seulement de la couche de fluage de manière à conserver une portion de la couche de fluage entre les plots.

Dans la suite de la description, les termes cristaux et cristallites seront considérés comme équivalents.

Il est précisé que dans le cadre de la présente invention, les termes « sur », « surmonte », « recouvre » ou « sous-jacent » ou leurs équivalents ne signifient pas « au contact de ». Ainsi par exemple, « le dépôt d'une première couche sur une deuxième couche » ne signifie pas obligatoirement que les deux couches sont directement au contact l'une de l'autre mais cela signifie que la première couche recouvre au moins partiellement la deuxième couche en étant soit directement à son contact soit en étant séparée d'elle par au moins une autre couche ou au moins un autre élément y compris de l'air. De même, « un plot surmontant une première couche » ne signifie pas que le plot est nécessairement au contact de cette première couche mais signifie que le plot est soit au contact de cette première couche soit au contact d'une ou plusieurs couches disposées entre la première couche et le plot.

Les étapes de formation des différentes couches et régions s'entendent au sens large : elles peuvent être réalisées en plusieurs sous-étapes qui ne sont pas forcément strictement successives.

Dans la description qui suit, l'épaisseur ou la hauteur est prise selon une direction perpendiculaire aux faces principales des différentes couches. Sur les figures, l'épaisseur ou la hauteur est prise selon la verticale ou selon l'axe z du repère orthogonal illustré en figures 1A à **1E****,** 3A à 3H et 5A et 5B.

De même lorsqu'on indique qu'un élément est situé au droit d'un autre élément, cela signifie que ces deux éléments sont situés tous deux sur une même ligne perpendiculaire au plan principal du substrat, soit sur une même ligne orientée verticalement (axe z) sur les figures.

On entend par un substrat, une couche, un dispositif, « à base » d'un matériau **M, un** substrat, une couche, un dispositif comprenant ce matériau M uniquement ou ce matériau M et éventuellement d'autres matériaux, par exemple des éléments d'alliage, des impuretés ou des éléments dopants.

Les termes « sensiblement », « environ », « de l'ordre de » signifient « à 10% près » ou, lorsqu'il s'agit d'une orientation angulaire, « à 10° près ». Ainsi, une direction sensiblement normale à un plan signifie une direction présentant un angle de 90±10° par rapport au plan.

Le terme « micro-LED » désigne une LED dont au moins une dimension prise dans un plan parallèle au plan principal dans lequel s'étend le substrat supportant la micro-LED (i.e., le plan XY du repère orthogonal référencé sur les figures) est micrométrique, c'est-à-dire strictement inférieure à 1 mm (10⁻³ mètres) et de préférence inférieure ou égale à 100 µm (1 µm = 10⁻⁶ mètres). Dans le cadre de l'invention les micro-LED présentent, en projection dans un plan d'extension principal parallèle aux faces principales des micro-LED, i.e., parallèle à une face supérieure du substrat, des dimensions maximales de dimension micrométrique dans le plan. De préférence ces dimensions maximales sont inférieures à quelques centaines de micromètres. De préférence ces dimensions maximales sont inférieures à 100µm.

Dans la présente invention, on entend par « dispositifs verticaux », les dispositifs dans lesquels les porteurs de charge se déplacent dans l'épaisseur de la couche, c'est-à-dire selon une direction perpendiculaire aux plans dans lesquels s'étendent les faces principales de cette couche.

Dans la présente invention, on entend par « transistors de type HEMT » (acronyme anglais de « High Electron Mobility Transistor ») des transistors à effet de champ à haute mobilité d'électrons, parfois également désignés par le terme de transistor à effet de champ à hétérostructure. Un tel transistor inclut la superposition de deux couches semiconductrices ayant des bandes interdites différentes qui forment un puit quantique à leur interface. Des électrons sont confinés dans ce puits quantique pour former un gaz bidimensionnel d'électrons. Pour des raisons de tenue en haute tension et en température, les matériaux de ces transistors sont choisis de façon à présenter une large bande d'énergie interdite.

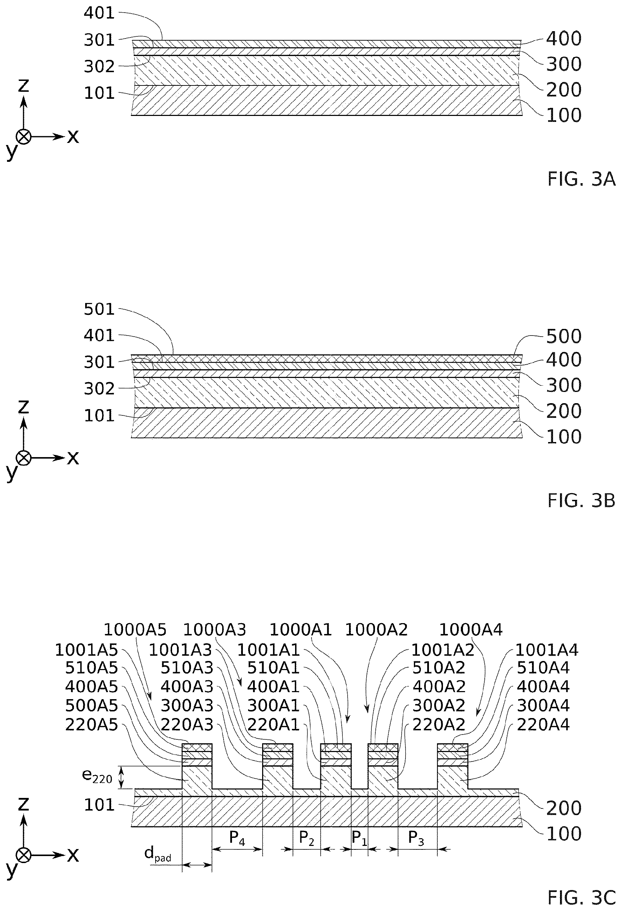

Un exemple de procédé de formation d'une couche continue selon l'invention va maintenant être décrit en référence aux figures 3A à 3H.

On notera que, selon un exemple, le procédé décrit ci-dessous permet de former une unique couche continue sur un substrat 100 ou sur une plaque. Selon un autre exemple, le procédé décrit ci-dessous permet de former une pluralité de couches continues sur un même substrat 100 ou sur une même plaque. Dans ce dernier cas, chaque couche est disjointe des autres et peut être qualifiée de vignette. Chaque vignette peut alors servir pour réaliser un dispositif tel qu'une LED ou une micro-LED ou tout autre dispositif vertical à base de nitrure tel qu'un transistor de type HEMT.

Comme illustré en figure 3A, on fournit un empilement comprenant au moins un substrat 100, surmonté successivement d'une couche de fluage 200 et d'une couche cristalline 300. Ainsi la couche de fluage 200 est disposée entre le substrat 100 et la couche cristalline 300.

Selon un exemple de réalisation, le substrat 100 est à base de silicium, amorphe ou cristallin. Il assure la tenue mécanique de l'empilement.

La couche cristalline 300 présente une face inférieure 302 en regard de la couche de fluage 200 et une face supérieure 301 dont la fonction est de servir de couche de base pour faire croître par épitaxie le nitrure de la couche continue 550A que l'on souhaite obtenir au final. Par exemple, la couche que l'on souhaite obtenir au final est une couche de nitrure de gallium GaN. Selon un exemple de réalisation, la couche cristalline 300 est à base de silicium monocristallin. Alternativement la couche cristalline 300 peut être à base de SiC ou de Al₂O₃.

De préférence, la couche de fluage 200 est faite d'un matériau visqueux. La couche de fluage 200 présente une température de transition vitreuse. Elle présente donc une transition vitreuse et présente le comportement des matériaux à transition vitreuse. Comme tous les matériaux présentant une température de transition vitreuse, la couche de fluage 200, sous l'effet d'une élévation de température, se déforme sans rompre et sans reprendre sa position initiale après une baisse de température. Au contraire, la couche cristalline 300 ne présente naturellement pas de transition vitreuse. La couche cristalline 300 se déforme, puis se disloque et peut rompre. Par conséquent, la couche de fluage 200 et la couche cristalline 300 sont différentes. La couche de fluage 200 n'est pas cristalline.

La couche fluage 200 est faite d'un matériau amorphe tel qu'un oxyde, de préférence un oxyde de silicium SiₓO_{y}, tel que le SiO₂. Le rôle de cette couche sera explicité dans la suite de la description.

De manière avantageuse mais non limitative, cet empilement comprenant le substrat 100, la couche de fluage 200 et la couche cristalline 300 constitue un substrat de type semiconducteur sur isolant, de préférence silicium sur isolant (SOI). Dans ce cas, la couche de fluage 200 est formée par la couche d'oxyde enterré (BOX) du substrat SOI.

Selon un exemple de réalisation avantageux illustré en figure 3A, on dépose, par épitaxie sur la face supérieure 301 de la couche cristalline 300, une couche tampon 400. Lorsque la couche continue 550A que l'on souhaite obtenir au final est formée de GaN et que la couche cristalline 300 est une couche à base de silicium, cette couche tampon 400 est typiquement en nitrure d'aluminium (AIN). Cela permet d'éviter le phénomène dit de «Melt-back etching» (gravure par refusion), généré par la très forte réactivité entre le silicium et le gallium aux températures usuelles d'épitaxie (1000/1100°C) et qui conduit à dégrader très fortement la couche continue 550A de GaN.

Typiquement, l'épaisseur de la couche d'AIN est comprise entre 10 et 200 nanomètres (10⁻⁹ mètres).

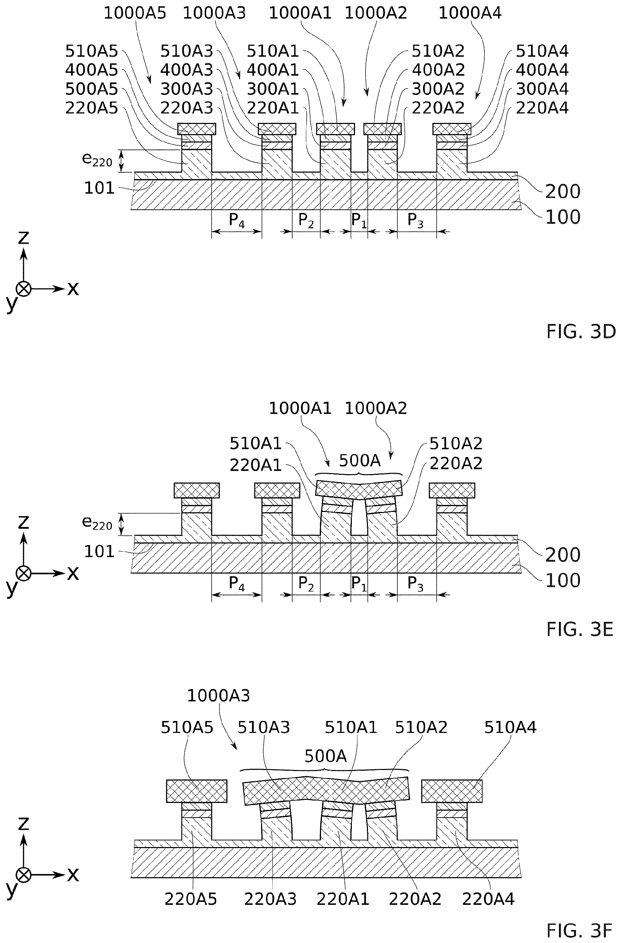

Comme illustré en figure 3B, on peut également déposer par épitaxie, sur la face supérieure 401 de la couche tampon 400, une couche d'amorçage 500. Cette couche d'amorçage 500 a pour fonction de faciliter la reprise de croissance des cristallites 510A1-510A5 lors des étapes suivantes. Dans ce cas, c'est à partir d'une face supérieure de la couche d'amorçage 500 que se produit en partie au moins la croissance par épitaxie des cristallites 510A1-510A5, les cristallites étant illustrées en figure 3D. Cette couche d'amorçage 500 est de préférence réalisée dans le même matériau que celui de la couche continue 550A que l'on souhaite obtenir au final. Typiquement, lorsque le matériau de la couche continue 550A est du nitrure de gallium GaN, la couche d'amorçage 500 est également en GaN. Cette couche d'amorçage 500 présente typiquement une épaisseur comprise entre 50 et 200 nanomètres.

Par souci de concision et de clarté, seuls cinq plots 1000A1-1000A5 sont représentés sur les figures pour supporter une couche continue 550A. Naturellement, une couche continue 550A peut être formée sur un nombre supérieur de plots. Comme cela sera décrit par la suite, le nombre de plots ainsi que leur période sera adaptée en fonction de la taille voulue pour la micro-LED.

On notera que les couches tampon 400 et d'amorçage 500 sont uniquement optionnelles. Ainsi, selon des modes de réalisation non illustrés en figures 3A à 3H, on pourra prévoir uniquement la couche tampon 400 ou uniquement la couche d'amorçage 500, ou encore aucune de ces deux couches 400 et 500.

Comme illustré en figure 3C, on forme ensuite des plots 1000A1-1000A5 à partir de l'empilement. Ces plots sont obtenus par gravure de l'empilement jusque dans la couche de fluage 200, une partie au moins de la gravure s'étendant au sein de la couche de fluage 200.

Pour former les plots par gravure, on pourra recourir aux nombreuses techniques de gravure connues de l'homme du métier. On pourra notamment utiliser les techniques classiques de lithographie, telles que les techniques de photolithographie comprenant la formation d'un masque, par exemple en résine, puis le transfert des motifs du masque dans l'empilement. On pourra également recourir aux techniques de lithographie par faisceau d'électrons (e-beam) ou aux techniques d'impression nanométrique.

Ces plots 1000A1-1000A5 sont de faibles dimensions et peuvent être qualifiés de nano-plots. Typiquement, la dimension maximale de la section des plots, prise dans un plan parallèle au plan horizontal XY du repère orthogonal XYZ ou au plan de la face supérieure 101 du substrat 100, et référencée dₚₗₒₜ en figure 3C, est comprise entre quelques dizaines et quelques centaines de nanomètres. Plus précisément, dₚₗₒₜ est comprise entre 10 et 500 nanomètres et de préférence entre 20 et 150 nm et de préférence entre 50 et 100 nm par exemple de l'ordre de 50nm ou de 100 nm. Si les plots sont de sections circulaires, cette dimension maximale dₚₗₒₜ correspond au diamètre des plots. Si les plots sont de section hexagonale, cette dimension maximale dₚₗₒₜ correspond à la diagonale ou au diamètre du cercle passant par les angles de l'hexagone. Si ces plots sont de section rectangulaire ou carrée cette dimension maximale dₚₗₒₜ correspond à la plus grande diagonale. Il est entendu que la section des plots peut présenter une forme autre que circulaire, hexagonale, rectangulaire ou carrée.

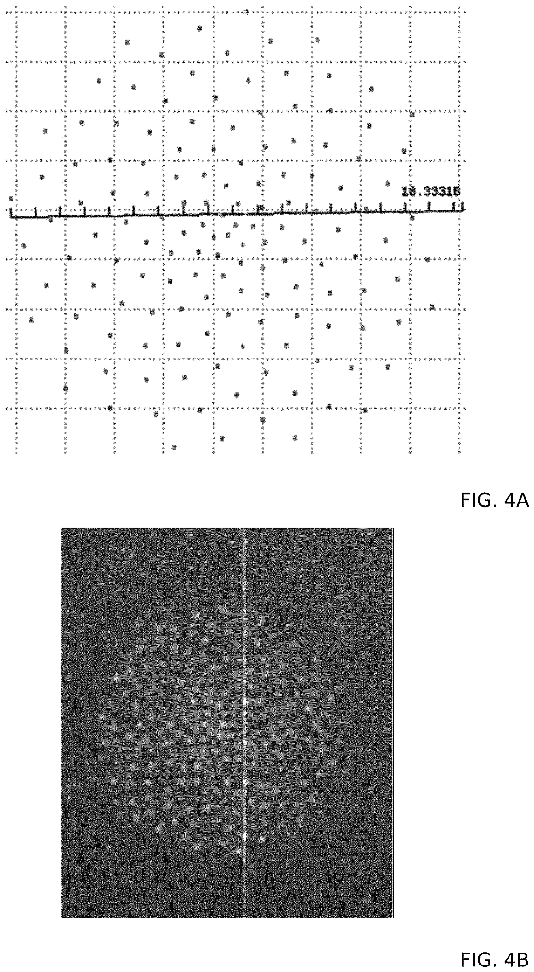

Dans le cadre de la présente invention, les plots 1000A1-1000A5 sont répartis de façon particulière en projection dans le plan XY : leur disposition est telle que, comme cela sera illustré plus avant, les coalescences intervenant successivement lors de la mise en œuvre du procédé mettent en jeu d'une part une seule cristallite 510A1 (lors de la première coalescence qui sera décrite plus loin en référence à la figure 3E) ou bien une pluralité de cristallites déjà coalescées 510A1-510A4 (lors des coalescences suivantes, figures 3F à 3H), et d'autre part au moins une cristallite isolée 510A2-510A5. Dit autrement, la disposition des plots 1000A1-1000A5 permet d'éviter toute coalescence entre d'une part une première pluralité de cristallites coalescées et d'autre part une deuxième pluralité de cristallites coalescées. Pour ce faire, les plots 1000A1-1000A5 ne présentent notamment pas tous la même distance avec leurs premiers voisins. La disposition des plots 1000A1-1000A5 doit notamment prendre en compte l'augmentation des dimensions en projection dans le plan XY des cristallites 510A1-510A5 au fur et à mesure de leur croissance par épitaxie. Des exemples de disposition des plots 1000A1-1000A5 seront donnés plus loin en référence aux figures 4A à 4F.

Comme illustré en figure 3C, les plots sont gravés à travers toute la couche d'amorçage 500, toute la couche tampon 400 (lorsque ces dernières sont présentes) et toute la couche cristalline 300. De préférence, seule une portion 220 de la couche de fluage 200 est gravée. Ce mode de réalisation présente pour avantage d'éviter que lors de l'épitaxie le nitrure de la couche continue 550Ase développe sur les tronçons de fluage 220. Cette sélectivité de l'épitaxie se rencontre notamment lorsque la couche continue 550A de nitrure que l'on fait croître par épitaxie est du GaN et que les tronçons de fluage sont en SiO₂. Au contraire, si, avec ces mêmes matériaux, la couche de fluage 200 est gravée sur toute son épaisseur, alors, lors de l'épitaxie, le nitrure de la couche continue 550A se développe à partir de la face supérieure 101 du substrat 100, habituellement formée de silicium. Cette situation n'est évidemment pas souhaitable.

Par ailleurs, il a été observé que le fait de conserver une portion 210 non gravée de la couche de fluage 200 permet de faciliter le fluage du tronçon 220, en particulier lorsque les cristallites sont désorientées en twist, c'est-à-dire dans des plans principaux d'extension de la couche continue 550A que l'on souhaite obtenir. Ces plans principaux d'extension de la couche continue 550A sont parallèles au plan horizontal XY du repère XYZ.

De manière préférée, l'épaisseur e₂₂₀ gravée, et formant donc la hauteur du tronçon de fluage 220, est égale à la moitié de l'épaisseur de la couche fluage 200. Cela permet d'avoir une très bonne réorientation des cristallites lors de la formation de joints de grains.

La figure 3D illustre la formation de cristallites 510A1-510A5 par croissance épitaxiale à partir de la couche d'amorçage 500 (ou de la face supérieure 301 de la couche cristalline 300 lorsque les couches 400 et 500 sont absentes).

Comme illustré sur cette figure 3D, les plots 1000A1-1000A5 supportent chacun une cristallite 510A1-510A5 portée par un empilement de tronçons 400A1-400A5, 300A1-300A5, 220A1-220A5. Les tronçons s'étendent selon la direction principale d'extension du plot, c'est-à-dire verticalement (Z) sur les figures 3A à 3H.

Les tronçons forment des cylindres circulaires si la section des plots est principalement circulaire. Si la section des plots 1000A1-1000A5 est polygonale, par exemple hexagonale, les tronçons forment alors des cylindres de section hexagonale. De préférence, les tronçons sont pleins. La section des plots est prise parallèlement au plan horizontal XY, soit parallèlement aux plans dans lesquels la couche fluage 220 et la couche cristalline 300 s'étendent principalement.

Quel que soit le mode de réalisation retenu, c'est-à-dire avec ou sans couche d'amorçage 500 et avec ou sans couche tampon 400, la croissance par épitaxie des cristallites 510A1-510A5, s'effectue en partie au moins ou uniquement à partir de la face supérieure 1001A1-1001A5 du plot 1000A1-1000A5. Ainsi, cette face supérieure 1001A1-1001A5 est formée soit par le tronçon cristallin 300A1-300A5, soit par le tronçon 500A1-500A5 formé par la couche d'amorçage 500, soit par le tronçon 400A1-400A5 formé par la couche tampon 400. Cela permet notamment d'obtenir rapidement des cristallites 510A1-510A5 d'épaisseur importante.

On remarquera que les faces supérieures 401, 501 de la couche tampon 400 et de la couche d'amorçage 500, c'est-à-dire les faces tournées au regard de la couche continue 550A que l'on souhaite faire croître, présentent des polarités de type Gallium (Ga), et non pas azote (N), ce qui facilite considérablement l'obtention d'une couche continue 550A de nitrure épitaxiée de grande qualité.

La croissance des cristallites 510A1-510A5 se poursuit et s'étend latéralement, en particulier selon des plans parallèles au plan xy. Les cristallites 510A1-510A5 se développent jusqu'à ce que celles portées par les deux plots les plus proches l'un de l'autre, référencés 1000A1 et 1000A2 sur les figures 3C à 3H et distants d'une distance P₁, coalescent (figure 3E). Cette coalescence a lieu sans dislocations ou avec peu de dislocations au sein des cristallites. Elle permet de former une couche continue 500A à partir des cristallites 510A1 et 510A2. Cette couche continue 500A constitue un ensemble coalescé.

La croissance des cristallites impliquées dans cette première coalescence 510A1, 510A2 ainsi que des autres cristallites 510A3-510A5 se poursuit jusqu'à ce que la couche continue 500A formée par les cristallites 510A1 et 510A2 coalesce avec la cristallite 510A3 portée par le plot 1000A3 le plus proche. La cristallite 510A3 vient ainsi s'ajouter à l'ensemble coalescé. Il est à noter que, du fait de la répartition des plots 1000A1-1000A5 sur le substrat, depuis le début de sa croissance (figure 3D) et jusqu'à cette étape du procédé (figure 3F), la cristallite 510A3 étant coalescée à la couche continue 550A n'a jamais coalescée avec une autre cristallite. Son plot 1000A3 présente donc toute la mobilité nécessaire pour accommoder les défauts d'alignement dans le plan XY ou hors plan avec la couche continue 550A formée par les deux premières cristallites coalescées 510A1, 510A2. Sur la figure 3F, une déformation du tronçon de fluage 220A3 selon son angle de « tilt » est illustrée. Une déformation de ce tronçon de fluage 220A3 selon l'angle de « twist » peut intervenir alternativement ou simultanément. Les propriétés de son tronçon de fluage 220A3 permettent de réduire significativement les défauts à l'interface entre la couche continue 550A et la cristallite 510A3. Des explications sur l'intérêt de cette précaution sont données plus avant.

La couche continue 500A est alors formée par les cristallites 510A1, 510A2 et 510A3.

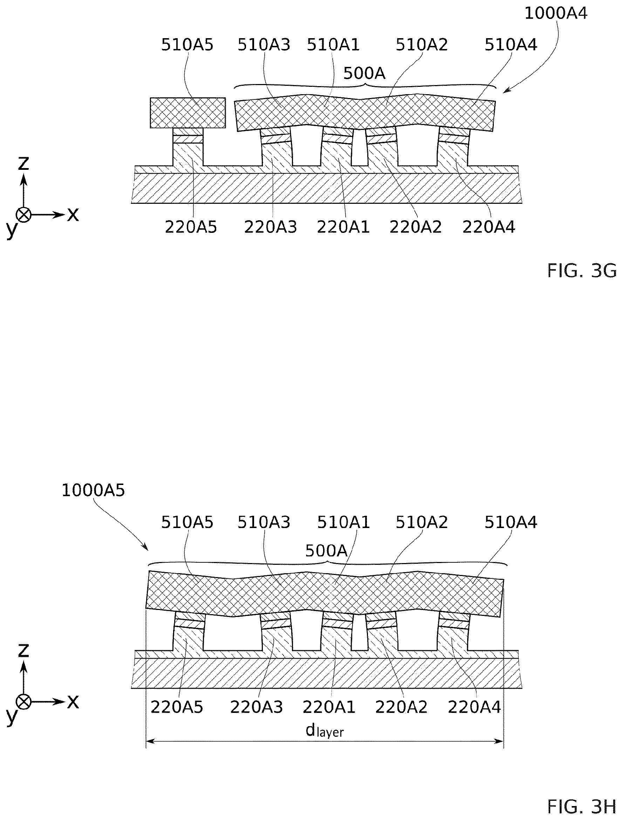

La croissance de la couche continue 500A se poursuit, ainsi que celle des cristallites non encore coalescées 510A4, 510A5. Une nouvelle coalescence survient lorsque la couche continue 500A entre en contact avec la cristallite 510A4 (figure 3G). Le tronçon de fluage 220A4 de cette dernière se déforme de manière à ce que le plot 1000A4 dans son intégralité se déforme et accommode ainsi tout désalignement et toute désorientation de la couche continue 500A avec la cristallite 510A4. Les cristallites 510A4 et 510A5 viennent ainsi s'ajouter à l'ensemble coalescé.

Enfin, la figure 3H illustre une coalescence permettant d'intégrer la cristallite 510A5 à la couche continue 500A (c'est-à-dire à l'ensemble coalescé).

Comme cela ressort clairement des figures, la couche continue 550A s'étend en fin de procédé entre plusieurs plots 1000A1-1000A5 et forme une couche continue.

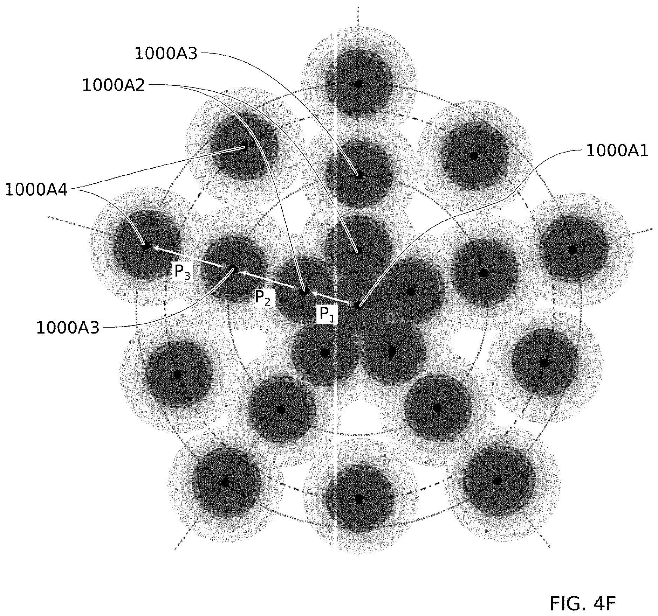

Il est entendu que les figures 3A à 3H illustrent l'exemple d'une couche continue 500A formée par ajout d'une seule cristallite 510 à chaque étape de coalescence, mais qu'il est parfaitement envisageable que plusieurs cristallites 510A1-510A5 coalescent simultanément à la couche continue 500A, dès lors que celles-ci ne sont pas elles-mêmes déjà coalescées entre elles ou à une ou plusieurs autres cristallites. Un tel exemple sera décrit plus avant en référence à la figure 4F.

Les figures 3A à 3H n'ont pas pour objectif de donner une représentation visuelle proche de la réalité concernant la déformation des tronçons du fluage. Ces figures visent à donner une représentation schématique pour comprendre facilement le principe de coalescence des cristallites sans dislocation au niveau des joints de coalescence. Notamment, les déformations des tronçons de fluage ne sont pas représentées dans tous les plans par souci de concision. Par ailleurs, les déformations des plots ont été exagérées à des fins explicatives. La surface supérieure de la couche continue obtenue en fin de procédé présente un aspect beaucoup moins rugueux que celui représenté, voire lisse.

La croissance des cristallites 510A1-510A5 ne s'étend pas vers le bas. Par ailleurs, cette croissance est sélective en ce qu'elle n'a pas lieu sur la couche de fluage 200, typiquement faite d'un oxyde. **En** ce sens, la croissance des cristallites 510A1-510A5 s'effectue selon le principe de pendeo-épitaxie.

On notera qu'il est particulièrement avantageux de graver les plots 1000A1-1000A5 après formation par épitaxie de la couche tampon 400 et de la couche d'amorçage 500 (lorsque ces couches sont présentes). **En** effet, si l'une de ces couches 400, 500 était déposée après gravure, elle se formerait en partie au moins entre les plots 1000A1-1000A5 sur la face supérieure de la couche de fluage 200. Dans le cas où le nitrure épitaxié est du GaN, que la couche de fluage 200 est du SiO₂, alors, à la température du dépôt par épitaxie, la croissance épitaxiale de la couche continue 550A de nitrure ne s'effectuerait pas de manière sélective mais aurait au contraire également lieu entre les plots 1000A1-1000A5, ce qui naturellement n'est pas souhaitable.

De manière particulièrement avantageuse, la température T_{épitaxie} à laquelle on effectue l'épitaxie est supérieure ou de l'ordre de la température T_{transition vitreuse} de transition vitreuse de la couche de fluage 200. Ainsi, lors de l'épitaxie, les tronçons de fluage 220A1-220A5 sont portés à une température qui leur permet de se déformer.

Par conséquent, si les cristallites 510A11-510A12 portées par deux plots 1000A1-1000A2 adjacents sont désorientées l'une par rapport à l'autre, lors de la coalescence de ces deux cristallites, le joint formé à leur interface, habituellement désigné joint de grains ou joint de coalescence, se formera sans dislocation pour rattraper ces désorientations. La déformation des tronçons de fluage 220 permet ainsi de rattraper ces désorientations et d'obtenir une couche continue 550A sans ou avec très peu de dislocations aux joints de coalescence.

On note d_{couche} la dimension maximale d'une couche continue mesurée parallèlement au plan xy. Ainsi, d_{couche} correspond à la dimension maximale d'une projection de la couche continue dans un plan parallèle au plan xy. De préférence 0,8 µm ≤ d_{couche} ≤ 3 µm et de préférence 1 µm ≤ d_{coucne} ≤ 2 µm. d_{couche} dépend de la vitesse et de la durée de la croissance épitaxiale ainsi que du nombre et de la dimension des plots.

Les distances (par exemple référencées P₁, P₂, P₃, P₄... sur les figures) séparant deux plots dont les cristallites sus-jacentes sont successivement coalescées à la couche continue sont typiquement supérieure à 300 nm, et par exemple comprises entre 300 nm et 10 µm, par exemple entre 300 nm et 5 µm. Ces distances peuvent notamment être choisies en fonction de la taille du composant que l'on souhaite fabriquer à partir de la couche continue formée en fin de procédé. L'augmentation de la distance entre plots à mesure que l'on considère des plots d'indice de plus en plus élevé se fait typiquement plus rapidement pour un composant de petite taille que pour un composant de grande taille. En effet, pour un composant de grande taille, on pourrait alors se retrouver avec des plots très éloignés. Or, il peut être complexe de réaliser la coalescence de cristallites appartenant à des plots très éloignés, notamment du fait qu'à un stade avancé du procédé, la couche continue est assez épaisse. Il est à noter cependant qu'une épaisseur importante de la couche continue peut être recherchée en vue de la fabrication de certains dispositifs, par exemple pour l'électronique de puissance. Il n'est donc pas exclu de réaliser des coalescences entre cristallites et la couche continue lorsque l'épaisseur de nitrure est importante (éventuellement jusqu'à plusieurs dizaines de micromètres).

Le procédé de réalisation de la couche continue 550A peut être arrêté à l'issue de la figure 3H. Alternativement, ce procédé peut être poursuivi pour former une micro-LED à partir de la couche continue 550A.

Selon un mode de réalisation non limitatif non illustré, on réalise des puits quantiques au sein de la couche continue 550A. Ce mode de réalisation permet avantageusement de réaliser directement une micro-LED de taille correspondant à la taille initiale de la couche continue. Pour réaliser des puits quantiques au sein de la couche continue 550A, l'homme du métier pourra mettre en œuvre les solutions connues de l'état de la technique. Ainsi, une fois que les cristallites 510A1-510A5 ont coalescé, on adopte les mêmes conditions de croissance pour les puits que lors d'une croissance bidimensionnelle classique.

La plus faible dimension possible pour les micro-LED est fonction de la résolution ultime des méthodes de structuration choisies : par exemple, pour des réseaux de plots élaborés par nanoimpression, on atteint des tailles de plots de 50 nm et des distances entre plots de 100 à 150 nm. Ce qui signifie que l'on obtient des dimensions d_{couche} de couches continues de 1 à 2 µm. Ceci est donc de l'ordre des tailles de pixels recherchées pour les µ-display haute résolution.

### Explication du principe de coalescence sans dislocation ou avec peu de dislocation(s) au sein des couches continues

Comme indiqué ci-dessus en référence aux figures 3E à 3H, la formation de la couche continue 500A passe par les coalescences successives de cristallites 510A1-510A5 isolées.

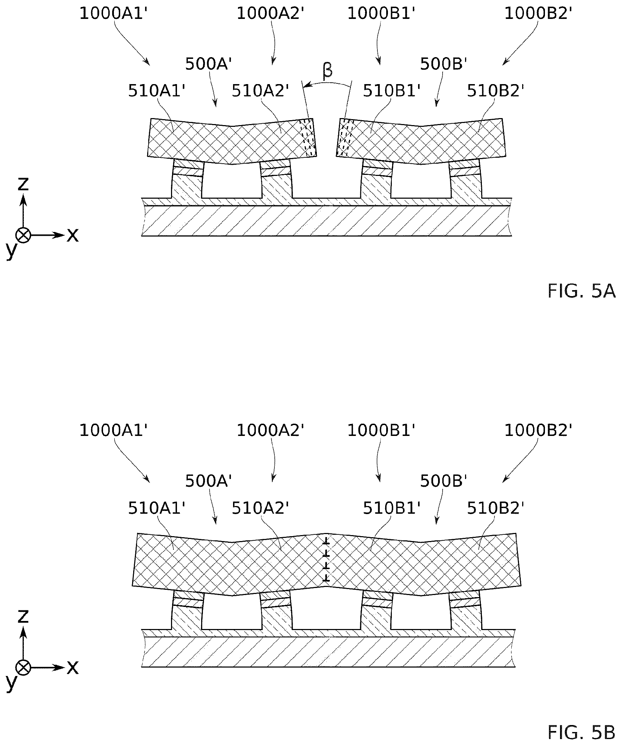

Tel qu'illustré aux figures 5A et 5B, la coalescence d'ensembles de cristallites déjà coalescées induit des défauts au niveau des joints de coalescence.

Les figures 5A et 5B illustrent l'exemple de deux couches continues 500A', 500B' ayant chacune été obtenue par coalescence de deux cristallites (510A1' et 510A2' d'une part, 510B1' et 510B2' d'autre part), chacune supportée par un plot (1000A1' et 1000A2' d'une part, 1000B1' et 1000B2' d'autre part). Les plans cristallins de ces deux couches présentent un défaut d'orientation angulaire repéré par l'angle β.

On pourrait s'attendre à ce que, comme dans le cas de la coalescence de deux cristallites isolées, ce défaut d'orientation soit compensé par les propriétés des tronçons de fluage de chacun des plots. Il a été remarqué cependant qu'une compensation ne s'opérait pas, ou du moins s'opérait dans des proportions insuffisantes pour limiter les défauts de coalescence de manière satisfaisante.

Cela s'explique par les éléments suivants. Lors d'une première coalescence d'une cristallite avec une cristallite voisine, le tronçon de fluage sous-jacent se déforme en fonction des désorientations relatives de ces deux premières cristallites. Passé cette première coalescence, le tronçon de fluage est donc contraint mécaniquement dans une direction dépendante de ces désorientations.

Si une nouvelle coalescence advient, on distingue alors deux cas :
a. La coalescence de la couche continue se fait avec une cristallite isolée (on qualifie de cristallite isolée ou unique une cristallite n'ayant pas encore coalescé avec une ou plusieurs autres cristallites) : le tronçon de fluage sous-jacent à cette cristallite isolée présente une grande liberté mécanique et peut à lui seul compenser les désorientations entre les réseaux cristallins de la couche continue et de la cristallite isolée. Il est entendu qu'une déformation des tronçons de fluage sous-jacents à la couche continue est également possible, dans une proportion bien plus faible que la déformation du tronçon de fluage sous-jacent à la cristallite isolée.
b. La coalescence de la couche continue se fait avec une autre continue, également obtenue par la coalescence de cristallites portées par plusieurs plots (cas illustré à la figure 5B) : les différents tronçons de fluage sont alors trop contraints du fait de leur dépendance mécanique à la couche continue et aux autres tronçons de fluage. Leur présence ne permet pas de compenser les désalignements entre les deux couches continues et celles-ci coalescent en provoquant de nombreux défauts au sein des cristallites, notamment au niveau du joint de coalescence. Il est entendu que les tronçons de fluage sous-jacents aux deux couches continues peuvent se déformer, mais dans une mesure trop faible pour compenser à eux seuls les désorientations des couches continues.

Autrement dit, les tronçons de fluage des plots 1000A1', 1000A2', 1000B1', 1000B2' supportant les cristallites impliquées 510A1', 510A2', 510B1', 510B2' dans une coalescence entre cristallites déjà coalescées présentent une mobilité bien plus faible que lorsque chacun d'entre eux supporte une cristallite isolée. C'est cette différence de mobilité qui explique pourquoi le principe de coalescence de cristallites crues par pendeo-épitaxie ne s'applique pas de manière satisfaisante à un réseau de plots aux dispositions relatives quelconques.

Les figures 5A et 5B illustrent le fait qu'un désalignement hors plan des couches continues 500A', 500B' n'est pas compensé par la présence des tronçons de fluage, mais il est entendu que la même observation peut être réalisée pour un défaut d'orientation dans le plan xy.

Comme expliqué plus haut, il a été remarqué que si une cristallite isolée est impliquée dans la coalescence, son tronçon de fluage permet à lui seul de compenser ses désalignements avec la couche continue. Ainsi, l'invention se propose de disposer les plots à la surface du substrat de manière à ce que seule cette situation soit rencontrée au cours de la formation progressive de la couche continue, et que la coalescence de deux couches continues issues chacune de plusieurs cristallites soit évitée. Ainsi, selon l'invention, en un point de coalescence, la coalescence progressive des cristallites 510A1-510A5 se fait toujours entre d'une part une seule cristallite 510A1 ou une pluralité de cristallites 510A1-510A4 coalescées et d'autre part une cristallite 510A2-510A5 isolée. On évite ainsi la formation de défauts structurels au sein des cristallites et donc de la couche continue lors des coalescences successives, ce qui permet d'obtenir in fine une couche continue d'excellente qualité.

Comme précédemment exprimé, cela n'empêche pas qu'au niveau de l'ensemble de plots, plusieurs coalescences aient lieu simultanément. Dans ce cas, une pluralité de cristallites ayant déjà au préalable coalescé peut entrer en coalescence, simultanément, avec une pluralité de cristallites isolées les unes des autres, c'est-à-dire n'ayant au préalable coalescée avec aucune autre cristallite.

Il est entendu que deux cristallites faisant partie de la couche continue formée par coalescences successives sont considérées comme coalescées entre elles, qu'elles aient été ou non en contact direct entre elles lors de la coalescence de l'une d'entre elles à la couche continue. De façon générale, toute cristallite de la couche continue est considérée coalescée à toutes les autres cristallites formant la couche continue, et ce dès son intégration par coalescence à la couche continue. La couche continue forme en effet un ensemble coalescé au sein duquel les limites entre cristallites ne peuvent être réellement définies, notamment à mesure que l'épitaxie avance. Ainsi, la coalescence progressive des cristallites qui est contrôlée lors du procédé selon l'invention s'entend comme la succession d'ajouts d'une ou plusieurs cristallites à la couche continue. Notamment, il est parfaitement envisageable qu'au cours du procédé selon l'invention, deux cristallites faisant partie de la couche continue entrent en contact et coalescent à nouveau entre elles, cette fois directement. Ces coalescences peuvent être désignées coalescences internes. Les coalescences internes n'entrent pas en compte pour la coalescence progressive des cristallites, puisqu'à l'occasion d'une coalescence interne, aucune cristallite ne vient s'ajouter à la couche continue. Comme cela sera abordé plus avant, des précautions en termes de disposition des plots pourront être prises de manière à optimiser ces coalescences internes.

Il est à noter qu'une variation de vitesse de croissance peut avoir lieu au cours du procédé du fait des variations inévitables du procédé (par exemple du fait de l'injection des précurseurs, de la variation de la température ou de la pression...). Ainsi, avantageusement, on prévoit que la variation de la distance entre plots depuis un centre de symétrie de la coalescence permette de compenser cette variation de vitesse de coalescence pour un même ensemble de plots. De cette manière, même sous l'effet d'une variation de la vitesse de coalescence, le principe de formation de la couche continue par coalescences successives de cristallites isolées est vérifié.

### Exemples de disposition des plots permettant une coalescence sans dislocation ou avec peu de dislocation(s) au sein des couches continues

Différents exemples de disposition des plots sur le substrat 100 permettant d'obtenir une couche continue présentant une faible densité de défauts vont maintenant être décrits en référence aux figures 4A à 4F.

Il est entendu que la disposition des plots s'entend comme leur répartition dans l'espace en projection dans le plan xy, et tout particulièrement en projection sur la face supérieure 101 du substrat 100.

La distance entre deux plots voisins est mesurée d'un bord d'un de ces deux plots à un bord de l'autre de ces deux plots, en projection dans le plan xy, comme illustré à la figure 3C.

Un premier exemple de disposition des plots 1000A1-1000A5 sur le substrat 100 est illustré aux figures 4A et 4B. Dans cet exemple, les plots 1000A1-1000A5 sont disposés selon une spirale logarithmique. Une telle spirale est une courbe dont l'équation polaire est de la forme r=ab^{θ}, avec a et b des réels positifs et r le rayon mesuré entre le centre de la spirale et le point de la courbe formant un angle θ avec un axe d'origine ici arbitraire du plan horizontal XY. Avantageusement, donc, les plots 1000A1-1000A5 sont disposés sur une courbe théorique de cette forme. La répartition des plots 1000A1-1000A5 sur cette courbe théorique est notamment choisie en fonction du niveau de contrôle des procédés en jeu, tout particulièrement du procédé d'épitaxie, et de leur variabilité. Plus le contrôle est bon, plus l'espacement entre deux plots consécutifs sur la courbe peut augmenter faiblement à mesure que l'on parcourt la courbe depuis l'origine.

La figure 4A illustre une disposition théorique suivant un tel modèle, tandis que la figure 4B est une photographie **MEB** en vue de dessus de plots disposés selon ce mode de réalisation.

Ce mode de réalisation est particulièrement avantageux car il permet une forte densité de plots à la surface du substrat, ce qui entraîne une coalescence rapide des cristallites. En effet, à paramètres de croissance épitaxiale identiques, plus la densité de plots est grande, plus la vitesse de coalescence est élevée. La densité de plots à la surface du substrat est définie en projection dans le plan horizontal XY comme le rapport entre la surface occupée par les plots sur la face supérieure 101 du substrat 100 et la surface de cette face supérieure 101 du substrat 100.

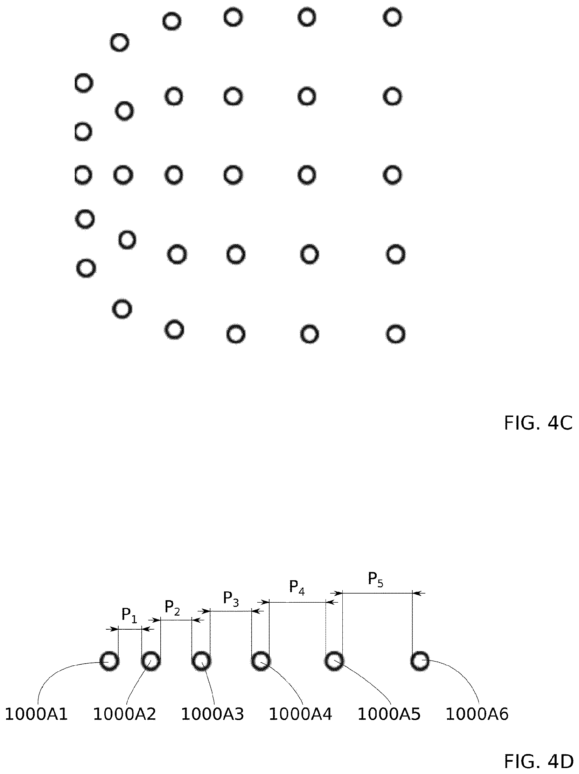

Selon un autre mode de réalisation illustré à la figure 4D, les plots sont alignés selon un unique axe, dit axe d'alignement. On définit un sens d'alignement de cet axe d'alignement ainsi qu'un point initial positionné sur ce même axe. Un premier plot 1000A1 se trouve sur cet axe d'alignement, par exemple sur le point initial. Les autres plots se trouvent également sur cet axe d'alignement, et la distance séparant deux plots consécutifs 1000A1-1000A6 est croissante lorsque l'on parcourt l'axe d'alignement dans le sens d'alignement. En notant P₁, P₂, P₃, P₄ et P₅ des distances séparant respectivement le premier 1000A1 et le deuxième 1000A2 plots, le deuxième 1000A2 et le troisième 1000A3 plots, le troisième 1000A3 et le quatrième 1000A4 plots, le quatrième 1000A4 et le cinquième 1000A5 plots et enfin le cinquième 1000A5 et le sixième 1000A6 plots, l'ordre des plots étant donné selon le sens d'alignement, on a ainsi : P₁<P₂<P₃<P₄<P₅. En notant i l'indice du plot sur l'axe d'alignement, avec i allant de 1 à N, N étant le nombre de plots disposés selon l'axe d'alignement, on a de préférence, pour i≥2, Pᵢ>1,1*Pᵢ₋₁. Avantageusement, la distance entre plots évolue, sur l'axe d'alignement et selon le sens d'alignement, selon une suite géométrique : pour i≥1, Pᵢ=aqⁱ, a et q étant des réels positifs, avec de préférence 2 ≤ q et/ou q ≥ 1,1.

Ce mode de réalisation peut être qualifié de disposition « en ligne ».

Selon un autre mode de réalisation illustré à la figure 4C, certains des plots sont disposés selon des axes d'alignement tels que définis précédemment en référence à la figure 4D. Ces axes d'alignement sont parallèles entre eux. Afin de permettre une bonne amorce de la coalescence en début de procédé, on prévoit également que d'autres plots ne soient pas nécessairement alignés sur un des axes d'alignement.

Les plots peuvent par exemple être disposés selon des axes parallèles entre eux et perpendiculaires aux axes d'alignement précédemment mentionnés. Ces axes sont désignés axes d'alignement secondaires. Les plots disposés sur un même axe d'alignement secondaire sont de préférence disposés selon un pas constant. Par ailleurs, en considérant l'ensemble des axes d'alignement secondaires dans la direction parallèle à tous les axes d'alignement et selon le même sens d'alignement que ces axes, le pas entre plots alignés sur un même axe d'alignement secondaire augmente. On prend garde dans cet exemple à ce que la distance séparant deux axes d'alignement successifs (pouvant également être vue comme le pas entre les plots sur les axes d'alignement secondaires) soit toujours supérieur au pas entre plots alignés selon les axes d'alignement. C'est cet exemple qui est illustré à la figure 4C.

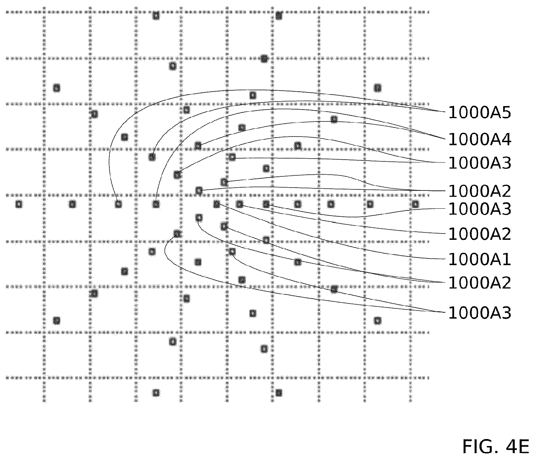

Selon un mode de réalisation illustré aux figures **4E** et 4F, les plots sont disposés selon une pluralité d'axes d'alignement concourants, par exemple cinq comme cela est représenté. On peut définir un point central, au niveau duquel se trouve ou non un plot, correspondant au point de concours de ces axes d'alignement. Les plots sont alors répartis sur des branches partant chacune du point central.

Avantageusement, et comme cela est mis en évidence à la figure 4F, les plots sont répartis sur des cercles concentriques.

Sur chacune des branches, les plots peuvent être disposés comme cela a été décrit pour un unique axe d'alignement, le point initial de l'axe d'alignement tel que défini dans le mode de réalisation précédent étant alors le point de concours des axes d'alignements ici définis.

Ce mode de réalisation peut être qualifié de disposition « en étoile ».

La figure 4F met en évidence l'ordre de coalescence des cristallites dans un exemple de ce mode de réalisation. Elle est une vue de dessus d'un ensemble de plots à différents stades d'avancement de la croissance épitaxiale des cristallites. Les plots sont représentés par les points noirs. Les différents disques concentriques autour d'un même plot correspondent à différents états d'avancement de la croissance de la cristallite supportée par ledit plot. Plus exactement, un disque correspond à un stade d'avancement de la croissance auquel une coalescence (ou plusieurs coalescences simultanées) survient (surviennent). Cette figure tient compte des coalescences internes telles que définies plus haut.

Dans cet exemple, un premier plot 1000A1 se trouve au niveau du point central de l'ensemble de plots et cinq deuxièmes plots 1000A2 se trouvent sur un premier cercle ayant pour centre le point central de l'ensemble de plots. Une première phase de croissance a lieu et se termine par la coalescence du premier plot 1000A1 avec les cinq deuxièmes plots 1000A2 (ces cinq coalescences ayant lieu sensiblement simultanément). Cette coalescence permet de former une couche continue.

Il est à noter que durant la première phase de croissance, la distance entre les deuxièmes plots 1000A2 et les troisièmes plots 1000A3 (et, plus généralement, tout autre plot d'autre supérieur) est suffisamment grande pour que leurs cristallites respectives ne coalescent pas à ce stade du procédé (i.e., P₂>P₁). Cela permet que les cristallites supportées par les deuxièmes plots 1000A2 soient bien des cristallites isolées lors de leur **coalescence** avec le premier plot 1000A1.

Lors d'une deuxième phase de croissance, l'ensemble des cristallites continue de croître, et ce jusqu'à coalescence de la couche continue avec les cristallites portées par des troisièmes plots 1000A3 (ici au nombre de cinq). Il est à noter là encore que durant la deuxième phase de croissance, la distance entre les troisièmes plots 1000A3 et les quatrièmes plots 1000A4 (et, plus généralement, tout autre plot d'autre supérieur) est suffisamment grande pour que leurs cristallites respectives ne coalescent pas à ce stade du procédé (i.e., P₃>P₂). Cela permet que les cristallites supportées par les troisièmes plots 1000A3 soient bien des cristallites isolées lors de leur coalescence avec la couche continue.

Les mêmes observations peuvent ensuite être faites pour la coalescence d'une part des troisièmes plots 1000A3 et d'autre part des quatrièmes plots 1000A4, respectivement lors d'une troisième et d'une quatrième phase de croissance.

Il est entendu que les différentes phases de croissance épitaxiale se déroulent typiquement de manière continue et qu'elles sont ici représentées et décrites séparément à des fins explicatives uniquement. Notamment, les cercles concentriques ne sont que des représentations schématiques de l'avancée de la croissance à différents instants du procédé mais n'ont aucune réalité physique à la fin du procédé.

Les différents exemples de disposition des plots 1000A1-1000A5 sur le substrat 100 décrits ci-dessus ont permis d'obtenir des couches continues de très bonne qualité, réduisant grandement la densité de défauts par rapport à des couches obtenus sans précautions sur la disposition des plots. Notamment, la symétrie de rotation admise par la répartition des plots autour du premier plot 1000A1 permet de limiter voire de supprimer les potentiels défauts engendrés par les coalescences internes dans la couche continue. Elle permet également de faciliter la fabrication des plots.

Il est entendu cependant que toute disposition des plots permettant la formation d'une couche continue uniquement par adjonctions de cristallites isolées à un cluster de cristallites (ou éventuellement, en début de procédé, à une autre cristallite isolée) permet d'obtenir des résultats tout aussi satisfaisants. Il est par exemple envisageable de retirer le plot central.

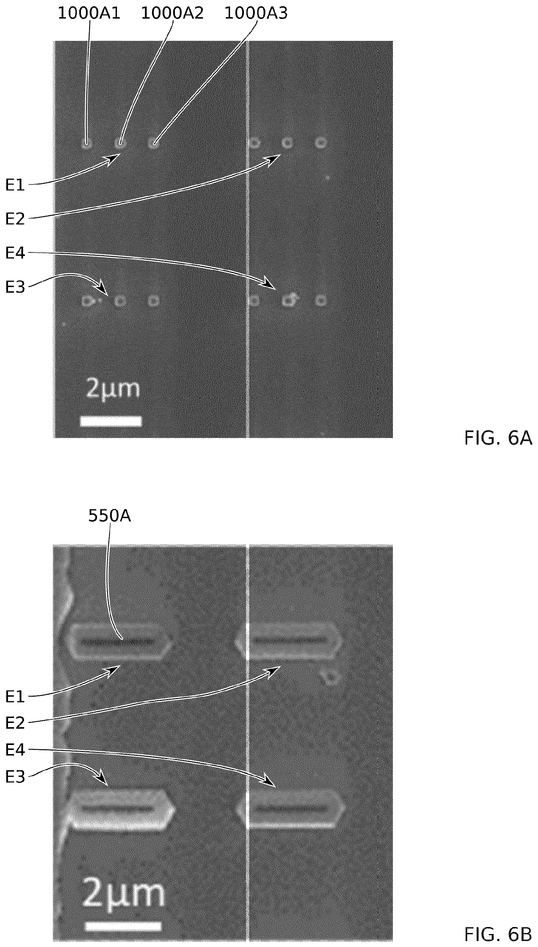

Les figures 6A, 6B, 7, 8A et 8B sont des résultats expérimentaux obtenus par mise en oeuvre du procédé selon l'invention tel que décrit ci-dessus. La figure 6A est une vue du dessus de quatre ensembles E1, E2, E3 E4 de chacun trois plots 1000A1, 1000A2, 1000A3 présentant chacun un tronçon de fluage en silicium surmonté d'un tronçon cristallin en GaN. Ces plots sont portés par un substrat SOI. Au sein d'un ensemble E1, E2, E3 E4, les plots sont disposés selon un axe d'alignement, comme dans le mode de réalisation décrit plus haut et schématisé à la figure 4D. Une croissance par épitaxie a été réalisée à partir de ces plots, jusqu'à coalescence des trois plots de chaque ensemble. Le résultat obtenu est présenté en figure 6B. Chaque ensemble de plot E1, E2, E3 E4 a permis de former une couche continue 550A de GaN.

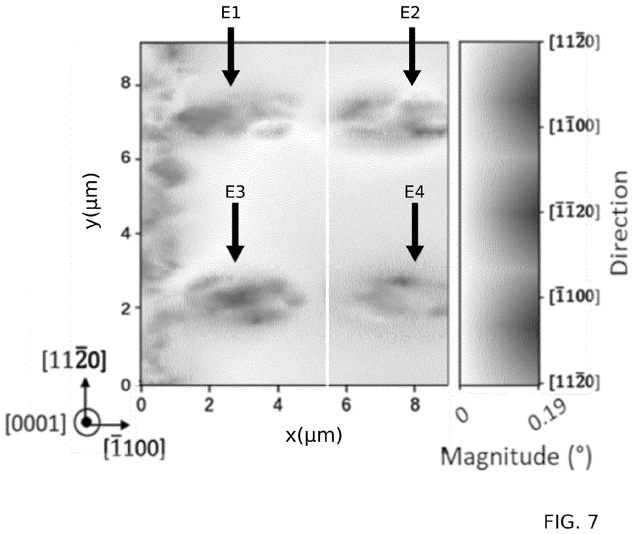

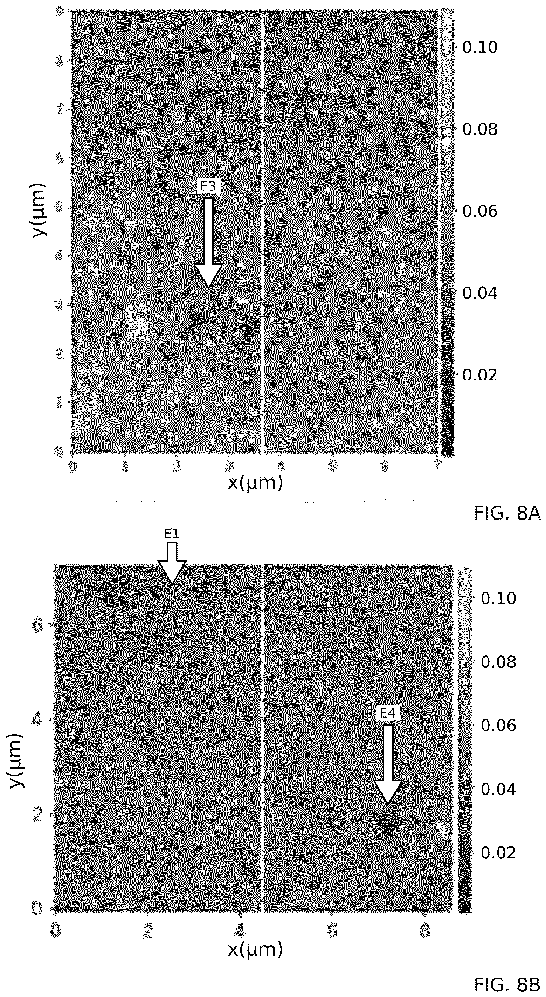

Les figures 7, 8A et 8B sont des résultats obtenus par analyse par diffraction des rayons X de l'ensemble.

La figure 7 montre l'orientation des couches continues de GaN obtenues après coalescence. On observe que les ensembles E3 et E4 notamment ont permis la formation de couches continues présentant une orientation très uniforme.

Les figures 8A et 8B montrent l'orientation des tronçons de silicium des plots après coalescence. On observe que les tronçons de silicium de l'ensemble E1 ont conservé une orientation très similaire entre le début et la fin du procédé. Les tronçons de silicium des ensembles E3 et E4 se sont pour leur part orientés différemment. Les tronçons se sont ainsi déformés pour mettre la formation d'une couche continue de GaN très alignée.

Ces figures illustrent ainsi le fait que l'alignement des couches continues de GaN par déformation des tronçons de fluage au cours du procédé fonctionne comme espéré.

L'exemple non limitatif décrit ci-dessus fait référence à l'utilisation de la couche de nitrure pour former une LED ou une micro-LED. Comme indiqué précédemment, cet exemple n'est pas limitatif. Le procédé décrit pourrait tout aussi bien servir à la réalisation d'autre dispositif à base de nitrure, par exemple des dispositifs verticaux tels que des transistors HEMT.

L'invention n'est pas limitée aux modes de réalisations précédemment décrits et s'étend à tous les modes de réalisation couverts par les revendications.

## Revendications

1. Procédé d'obtention d'une couche faite au moins en partie d'un nitrure (N) obtenu de préférence à partir d'au moins l'un parmi le gallium (Ga), l'indium (In) et l'aluminium (AI), le procédé comprenant les étapes suivantes :
• fournir un empilement comprenant au moins un ensemble de plots (1000A1-1000B4) s'étendant depuis un substrat (100), chaque plot (1000A1-1000B4) comprenant au moins :
i. un premier tronçon, dit tronçon de fluage (220A1- 220A5), formé dans un matériau amorphe présentant une température de transition vitreuse T_{transition vitreuse},
ii. un deuxième tronçon, cristallin, dit tronçon cristallin (300A1-300A5), surmontant le tronçon de fluage (200A1-200A5),
• faire croître par épitaxie une cristallite (510A1-510A5) sur certains au moins desdits plots (1000A1-1000A5) et poursuivre la croissance épitaxiale des cristallites (510A1-510A5) jusqu'à coalescence des cristallites (510A1-510A5) portées par les plots (1000A1-1000A5) de l'ensemble de plots, de manière à former une couche continue (550A) de nitrure,
le procédé étant **caractérisé en ce que** les plots (1000A1-1000A5) dudit ensemble de plots sont répartis sur le substrat (100) de façon à ce que la disposition relative des plots de l'ensemble de plots soit telle qu'au cours de l'épitaxie des cristallites (510A1-510A5), la coalescence progressive des cristallites (510A1-510A5) se fait toujours entre d'une part un ensemble, dit ensemble coalescé, comprenant une cristallite (510A1) ou une pluralité de cristallites (510A1-510A4) coalescées et d'autre part au moins une cristallite, dite cristallite isolée (510A2-510A5), n'ayant pas déjà coalescé avec d'autres cristallites.

2. Procédé selon la revendication précédente, dans lequel les plots (1000A1-1000A5) portant les cristallites formant la couche continue (550A) de nitrure sont disposés, en projection dans un plan horizontal (XY) dans lequel s'étend la face supérieure (101) du substrat (100), selon une spirale logarithmique.

3. Procédé selon la revendication 1, dans lequel les plots (1000A1-1000A5) portant les cristallites formant la couche continue (550A) de nitrure sont, en projection dans un plan horizontal (XY) dans lequel s'étend la face supérieure (101) du substrat (100), alignés selon au moins un axe dit d'alignement.

4. Procédé selon la revendication précédente, dans lequel les plots (1000A1-1000A5) disposés sur un même axe d'alignement sont espacés d'une distance croissante en parcourant l'axe d'alignement selon un sens donné à partir d'un point donné, dit point initial.

5. Procédé selon l'une quelconque des deux revendications précédentes, dans lequel les plots (1000A1-1000A5) portant les cristallites formant la couche continue (550A) sont séparés d'une distance variant de façon logarithmique de proche en proche, ladite distance étant mesurée selon leur axe d'alignement.

6. Procédé selon la revendication 1, dans lequel les plots (1000A1-1000A5) portant les cristallites formant la couche continue (550A) de nitrure sont alignés, en projection dans un plan horizontal (XY) dans lequel s'étend la face supérieure (101) du substrat (100), selon des axes concourants, les axes concourants vérifiant entre eux une symétrie de rotation autour d'un point central en projection dans le plan horizontal (XY).

7. Procédé selon la revendication précédente, dans lequel les plots (1000A1-1000A5) sont alignés selon cinq axes concourants.

8. Procédé selon l'une quelconque des revendications précédentes dans lequel la croissance épitaxiale est effectuée à une température T_{épitaxie}, telle que T_{épitaxie} > k₁ x Tₜᵣₐₙₛᵢₜᵢₒₙ vitreuse, avec k₁ ≥ 0,8.

9. Procédé selon la revendication précédente, dans lequel k₁ ≥ 1, et de préférence k₁ ≥ 1,5.

10. Procédé selon l'une quelconque des revendications précédentes dans lequel l'ensemble de plots comprend au moins 3 plots.

11. Procédé selon l'une quelconque des revendications précédentes dans lequel l'empilement comprend une pluralité d'ensembles de plots sur le substrat, une couche continue de nitrure étant formée à partir de chaque ensemble de plots, la croissance par épitaxie des cristallites étant interrompue avant que les cristallites appartenant à deux ensembles de plots distincts n'entrent en coalescence, de sorte à ce que les couches continues formées à partir de chaque ensemble de plots soient distantes les unes des autres.

12. Procédé selon l'une quelconque des revendications précédentes, dans lequel chaque plot (1000A1-1000A5) présente une face supérieure (1001A1) et dans lequel la croissance par épitaxie des cristallites (510A1-510A5) s'effectue en partie au moins et de préférence uniquement à partir de ladite face supérieure (1001A1).

13. Procédé selon l'une quelconque des revendications précédentes comprenant en outre une étape de formation dans la couche continue (550A) d'un dispositif, le dispositif étant pris parmi une LED et un transistor, par exemple un transistor vertical, par exemple un transistor de type HEMT.

14. Procédé selon l'une quelconque des revendications précédentes dans lequel les plots (1000A1-1000A5) dudit ensemble de plots sont répartis sur le substrat (100) de façon à ce que la disposition relative des plots de l'ensemble de plots soit telle qu'au cours de l'épitaxie des cristallites (510A1-510A5), au moins à certains instants la coalescence progressive des cristallites (510A1-510A5) se fait entre d'une part ledit ensemble coalescé et d'autre part plusieurs cristallites isolées (510A2-510A5).

## Patentansprüche

1. Verfahren zum Erhalten einer Schicht, die mindestens zum Teil aus einem Nitrid (N) hergestellt ist, das bevorzugt ausgehend von mindestens einem von Gallium (Ga), Indium (In) und Aluminium (Al) erhalten wird, wobei das Verfahren die folgenden Schritte umfasst:
• Bereitstellen einer Stapelung, die mindestens eine Einheit von Stiften (1000A1- 1000B4) umfasst, die sich ausgehend von einem Substrat (100) erstrecken, wobei jeder Stift (1000A1- 1000B4) mindestens Folgendes umfasst:
i. einen ersten Abschnitt, Kriechabschnitt (220A1-220A5) genannt, der aus einem amorphen Material gebildet ist, das eine Glasübergangstemperatur T_{Glasübergang} umfasst,
ii. einen zweiten kristallinen Abschnitt, kristalliner Abschnitt (300A1-300A5) genannt, der den Kriechabschnitt (200A1-200A5) überragt,
• Aufwachsen durch Epitaxie eines Kristallits (510A1-510A5) auf mindestens bestimmten der Stifte (1000A1-1000A5) und Fortsetzen des epitaktisches Wachstums der Kristallite (510A1-510A5) bis zum Zusammenwachsen der Kristallite (510A1- 510A5), die von den Stiften (1000A1-1000A5) der Einheit von Stiften getragen werden derart, dass eine zusammenhängende Nitridschicht (550A) gebildet wird,
Verfahren **dadurch gekennzeichnet, dass** die Stifte (1000A1-1000A5) ein und derselben Einheit von Stiften auf dem Substrat (100) derart verteilt sind, dass die relative Anordnung der Stifte der Einheit von Stiften derart ist, dass im Laufe der Epitaxie der Kristallite (510A1-510A5) das allmähliche Zusammenwachsen der Kristallite (510A1-510A5) immer erfolgt zwischen einerseits einer Einheit, zusammengewachsene Einheit genannt, die einen Kristallit (510A1) oder eine Vielzahl zusammengewachsener Kristallite (510A1-510A4) und andererseits mindestens einem Kristallit, isolierter Kristallit (510A2-510A5) genannt, der noch nicht mit anderen Kristalliten zusammengewachsen ist, umfasst.

2. Verfahren nach dem vorstehenden Anspruch, wobei die Stifte (1000A1- 1000A5), die die Kristallite tragen, die die zusammenhängende Nitridschicht (550A) bilden, in einer horizontalen Ebene (XY) in Projektion angeordnet sind, in der sich die obere Fläche (101) des Substrats (100) gemäß einer logarithmischen Spirale erstreckt.

3. Verfahren nach Anspruch 1, wobei die Stifte (1000A1-1000A1-1000A5), die die Kristallite tragen, die die zusammenhängende Nitridschicht (550A) bilden, in Projektion in einer horizontalen Ebene (XY), in der sich die obere Fläche (101) des Substrats (100) erstreckt, gemäß mindestens einer Ausrichtungsachse genannten Achse ausgerichtet sind.

4. Verfahren nach dem vorstehenden Anspruch, wobei die Stifte (1000A1-1000A5), die auf ein und derselben Ausrichtungsachse angeordnet sind, beim Durchlaufen der Ausrichtungsachse entlang einer gegebenen Richtung ausgehend von einem gegebenen Punkt, Ausgangspunkt genannt, um einen zunehmenden Abstand beabstandet sind.

5. Verfahren nach einem der beiden vorstehenden Ansprüche, wobei die Stifte (1000A1-1000A5), die die Kristallite tragen, die die zusammenhängende Schicht (550A) bilden, um einen Abstand getrennt sind, der logarithmisch von einem zum nächsten variiert, wobei der Abstand entlang ihrer Ausrichtungsachse gemessen wird.

6. Verfahren nach Anspruch 1, wobei die Stifte (1000A1-1000A5), die die Kristallite tragen, die die zusammenhängende Nitridschicht (550A) bilden, in Projektion in einer horizontalen Ebene (XY), in der sich die obere Fläche (101) des Substrats (100) erstreckt, gemäß konvergierenden Achsen ausgerichtet sind, wobei die konvergierenden Achsen untereinander eine Rotationssymmetrie um einen zentralen Punkt in Projektion in der horizontalen Ebene (XY) aufweisen.

7. Verfahren nach dem vorstehenden Anspruch, wobei die Stifte (1000A1-1000A5) gemäß fünf konvergierenden Achsen ausgerichtet sind.

8. Verfahren nach einem der vorstehenden Ansprüche, wobei das epitaktische Aufwachsen bei einer Temperatur T_{Epitaxie} derart erfolgt, dass T_{Epitaxie} > k₁ x T_{Glasübergang} ist, wobei k₁ ≥ 0,8.

9. Verfahren nach dem vorstehenden Anspruch, wobei k₁ ≥ 1, und bevorzugt k₁ ≥ 1,5.

10. Verfahren nach einem der vorstehenden Ansprüche, wobei die Einheit von Stiften mindestens 3 Stifte umfasst.

11. Verfahren nach einem der vorstehenden Ansprüche, wobei die Stapelung eine Vielzahl von Einheiten von Stiften auf dem Substrat umfasst, wobei eine zusammenhängende Nitridschicht ausgehend von jeder Einheit von Stiften gebildet wird, wobei das epitaktische Aufwachsen der Kristallite unterbrochen wird, bevor die Kristallite, die zu zwei getrennten Einheiten von Stiften gehören, zusammenzuwachsen beginnen, so dass die ausgehend von jeder Einheit von Stiften gebildeten zusammenhängenden Schichten voneinander beabstandet sind.

12. Verfahren nach einem der vorstehenden Ansprüche, wobei jeder Stift (1000A1-1000A5) eine obere Fläche (1001A1) aufweist, und wobei das epitaktische Aufwachsen der Kristallite (510A1-510A5) mindestens zum Teil und bevorzugt nur ausgehend von der oberen Fläche (1001A1) erfolgt.

13. Verfahren nach einem der vorstehenden Ansprüche, das außerdem einen Schritt des Bildens in der zusammenhängenden Schicht (550A) einer Vorrichtung umfasst, wobei die Vorrichtung genommen wird aus einer LED und einem Transistor, beispielsweise einem vertikalen Transistor, beispielsweise einem Transistor vom Typ HEMT.

14. Verfahren nach einem der vorstehenden Ansprüche, wobei die Stifte (1000A1-1000A5) der Einheit von Stiften auf dem Substrat (100) derart verteilt sind, dass die relative Anordnung der Stifte der Einheit von Stiften derart ist, dass im Laufe der Epitaxie der Kristallite (510A1-510A5) mindestens in bestimmten Augenblicken das allmähliche Zusammenwachsen der Kristallite (510A1-510A5) zwischen einerseits der zusammengewachsenen Einheit und andererseits mehreren isolierten Kristalliten (510A2-510A5) erfolgt.

## Claims

1. Method for obtaining a layer, at least partially made of a nitride (N) obtained preferably from at least one from among gallium (Ga), indium (In) and aluminium (Al), the method comprising the following steps:
• providing a stack comprising at least one assembly of pads (1000A1-1000B4) extending from a substrate (100), each pad (1000A1-1000B4) comprising at least:
i. one first section, called creep section (220A1- 220A5), formed in an amorphous material having a vitreous transition temperature T_{vitreous transition},
ii. one second section, crystalline, called crystalline section (300A1-300A5), surmounting the creep section (200A1-200A5),
• epitaxially growing a crystallite (510A1-510A5) on at least some of said pads (1000A1-1000A5) and continuing the epitaxial growth of the crystallites (510A1-510A5) until coalescence of the crystallites (510A1-510A5) carried by the pads (1000A1-1000A5) of the assembly of pads, so as to form a continuous nitride layer (550A),
the method being **characterised in that** the pads (1000A1-1000A5) of said assembly of pads are distributed over the substrate (100) such that the relative arrangement of the pads of the assembly of pads is such that during the epitaxy of the crystallites (510A1-510A5), the progressive coalescence of the crystallites (510A1-510A5) is always done between, on the one hand, an assembly, called coalesced assembly, comprising a crystallite (510A1) or a plurality of coalesced crystallites (510A1-510A4) and, on the other hand, at least one crystallite, called isolated crystallite (510A2-510A5), not having already coalesced with other crystallites.

2. Method according to the preceding claim, wherein the pads (1000A1-1000A5) carrying the crystallites forming the continuous nitride layer (550A) are disposed, projecting into a horizontal plane (XY) into which the upper face (101) of the substrate (100) extends, along a logarithmic spiral.

3. Method according to claim 1, wherein the pads (1000A1-1000A5) carrying the crystallites forming the continuous nitride layer (550A) are, projecting into a horizontal plane (XY) into which the upper face (101) of the substrate (100) extends, aligned along at least one so-called axis of alignment.

4. Method according to the preceding claim, wherein the pads (1000A1-1000A5) disposed on one same axis of alignment are spaced apart by an increasing distance by travelling the axis of alignment along a given direction from a given point, called initial point.

5. Method according to any one of the two preceding claims, wherein the pads (1000A1-1000A5) carrying the crystallites forming the continuous layer (550A) are separated by a distance varying logarithmically step by step, said distance being measured along their axis of alignment.

6. Method according to claim 1, wherein the pads (1000A1-1000A5) carrying the crystallites forming the continuous nitride layer (550A) are aligned, projecting into a horizontal plane (XY) into which the upper face (101) of the substrate (100) extends, along concurrent axes, the concurrent axes verifying between them, a symmetry of rotation around a central point, projecting into the horizontal plane (XY).

7. Method according to the preceding claim, wherein the pads (1000A1-1000A5) are aligned along five concurrent axes.

8. Method according to any one of the preceding claims, wherein the epitaxial growth is done at a temperature T_{epitaxy}, such that T_{epitaxy} > k₁ x T_{vitreous transition}, with k₁ ≥ 0.8.

9. Method according to the preceding claim, wherein k₁ ≥ 1, and preferably k₁ ≥ 1.5.

10. Method according to any one of the preceding claims, wherein the assembly of pads comprises at least 3 pads.

11. Method according to any one of the preceding claims, wherein the stack comprises a plurality of assemblies of pads on the substrate, a continuous nitride layer being formed from each assembly of pads, the epitaxial growth of crystallites being interrupted before the crystallites belonging to two distinct assemblies of pads come into coalescence, such that the continuous layers formed from each assembly of pads are distant from one another.

12. Method according to any one of the preceding claims, wherein each pad (1000A1-1000A5) has an upper face (1001A1) and wherein the epitaxial growth of the crystallites (510A1-510A5) is done at least partially and preferably only from said upper face (1001A1).

13. Method according to any one of the preceding claims, further comprising a formation step of a device in the continuous layer (550A), the device being taken from among an **LED** and a transistor, for example, a vertical transistor, for example, an **HEMT-**type transistor.

14. Method according to any one of the preceding claims, wherein the pads (1000A1-1000A5) of said assembly of pads are distributed over the substrate (100) such that the relative arrangement of the pads of the assembly of pads is such that during the epitaxy of the crystallites (510A1-510A5), at least at certain instants, the progressive coalescence of the crystallites (510A1-510A5) is done between, on the one hand, said coalesced assembly and, on the other hand, several isolated crystallites (510A2-510A5).
